# FASCICULE DE BREVET EUROPEEN

(11) **EP 2 351 095 B1**
(45) Date de publication et mention de la délivrance du brevet: **05.12.2012**
(21) Numéro de dépôt: 09756307.6
(22) Date de dépôt: 20.11.2009
(51) Int. Cl.: H01L 31/0352, H01L 31/0384, H01L 31/068, H01L 31/072

(54) **Cellule photovoltaïque a émetteur distribué dans un substrat et procédé de réalisation d'une telle cellule**
Photovoltaikzellen mit in einem Substrat verteiltem Sender und Verfahren zur Herstellung einer solchen Zelle
Photovoltaic cell with transmitter distributed in a substrate, and method for making such cell

(30) Priorité: 21.11.2008 FR 0857926
(43) Date de publication de la demande: 03.08.2011
(73) Titulaire: Commissariat à l'Énergie Atomique et aux Énergies Alternatives, 75015 Paris (FR)
(72) Inventeur: GARANDET, Jean-Paul, F-73370 Le Bourget Du Lac (FR); FEDERZONI, Luc, F-38300 Bourgoin-jallieu (FR); VESCHETTI, Yannick, F-29900 Concarneau (FR)
(74) Mandataire: Ilgart, Jean-Christophe
(86) Numéro de dépôt international: PCT/EP2009/065521
(87) Numéro de publication internationale: WO 2010/057964

(56) Documents cités:
- JP-A- 61 292 381
- US-A1- 2006 234 505
- US-A1- 2007 134 840
- US-B1- 7 253 017

## Description

### DOMAINE TECHNIQUE

L'invention concerne le domaine des cellules photovoltaïques, et notamment celui des cellules photovoltaïques à contacts arrières, c'est-à-dire à contacts situés sur la face de la cellule ne recevant pas les photons. L'invention concerne également la réalisation de cellules photovoltaïques à partir de semi-conducteurs de qualité inférieure à la qualité standard utilisée en microélectronique.

### ÉTAT DE LA TECHNIQUE ANTÉRIEURE

Les cellules photovoltaïques sont principalement fabriquées à partir de substrats de silicium monocristallin ou polycristallin obtenus en solidifiant des lingots à partir d'un bain liquide de silicium, puis en découpant des tranches de ce lingot pour obtenir les substrats, ou plaquettes. Différentes techniques de dépôt sur ces substrats de silicium sont ensuite mises en oeuvre en salle blanche pour réaliser les cellules photovoltaïques.

Lors de la réalisation d'une cellule photovoltaïque par la technologie classique appelée « homojonction », les lingots de silicium cristallisés sont tout d'abord découpés en plaquettes sur lesquelles sont fabriquées les cellules. Ces plaquettes sont alors texturées par attaque chimique pour améliorer le piégeage de la lumière par les cellules photovoltaïques qui seront réalisées à partir de ces plaquettes. Des jonctions p-n sont ensuite réalisées par diffusion gazeuse dans ces plaquettes. Un dépôt PECVD est ensuite mis en oeuvre pour améliorer les propriétés antireflets de la cellule et passiver les défauts recombinants. Des couches conductrices sont ensuite déposées par sérigraphie sur les deux faces pour permettre la collecte des porteurs photo-générés et la prise des contacts électriques de la cellule photovoltaïque.

Toutefois, avec ce type de technologie dite « homojonction », les rendements énergétiques atteints au niveau industriel sont limités, typiquement de l'ordre de 15%, et ce même avec un silicium de base de qualité « microélectronique ».

Pour obtenir des rendements supérieurs à 20%, il est nécessaire de faire appel à des cellules photovoltaïques de structures différentes, telles que des cellules photovoltaïques à hétérojonctions (Si amorphe / Si cristallin) et/ou des cellules de type RCC (Rear Contact Cell, ou cellule à contacts arrières) qui permettent notamment de s'affranchir de l'ombrage lié à la présence des conducteurs de collecte sur la face avant de la cellule (tous les contacts se trouvant alors sur la face arrière de la cellule).

Quelque soit le type de cellule réalisée, l'obtention de rendements énergétiques intéressants suppose que le maximum de porteurs minoritaires photo-générés au coeur de la cellule vont pouvoir atteindre la jonction p-n pour être collectés, et donc que leur longueur de diffusion soit supérieure à l'épaisseur de la plaquette. C'est tout particulièrement le cas pour les cellules RCC, dans la mesure où les porteurs sont principalement générés dans les premiers microns du silicium éclairé, au niveau de la face avant de la cellule, et doivent donc traverser toute la plaquette avant d'être collectés. La réalisation d'une cellule de type RCC nécessite donc l'utilisation de monocristaux élaborés à partir de silicium de qualité microélectronique qui offre une grande longueur de diffusion des porteurs minoritaires, mais qui a pour inconvénient majeur d'être coûteux.

D'autres types de silicium moins coûteux existent mais présentent une pureté moindre, se traduisant par une longueur de diffusion des porteurs minoritaires réduite. Ces silicium de moins bonne qualité ne peuvent donc pas être utilisés pour la réalisation de cellules de type RCC.

Il existe également des cellules photovoltaïques de type EWT (Emitter Wrap Through). Ces cellules sont réalisées à partir d'une plaquette de silicium, par exemple de type p. Des trous (dont le diamètre est égal à environ 60 µm, et espacés de 2 mm environ) sont réalisés par gravure laser à travers la plaquette de silicium. L'émetteur de la cellule est ensuite formé par la réalisation d'une couche de type n+ par diffusion gazeuse sur la face avant, dans les parois des trous, ainsi que sur une partie de la face arrière de la cellule. Ainsi, on répartit la jonction p-n+ dans le volume de la cellule des zones, permettant de réduire la distance à parcourir par un porteur minoritaire avant sa collecte.

De telles cellules EWT ont toutefois pour inconvénient majeur d'avoir un coût de fabrication élevé du fait de leur réalisation qui doit se faire nécessairement en salle blanche et de l'utilisation d'un laser pour la réalisation des trous dans le substrat.

Des cellules photovoltaïques telles que celles décrites dans le préambule de la revendication 1 sont connues du document JP 61292381 A.

### EXPOSÉ DE L'INVENTION

Un but de la présente invention est de proposer une nouvelle architecture de cellule photovoltaïque optimisant la collecte et le transport des porteurs de charge minoritaires dans la cellule photovoltaïque, et dont le coût de réalisation soit réduit et pouvant être réalisée à partir de semi-conducteur de qualité inférieure à la qualité microélectronique.

Pour cela, la présente invention propose selon la revendication 1.

L'émetteur de cette cellule photovoltaïque est distribué sous forme de plusieurs portions semi-conductrices réparties dans des trous borgnes, dans le coeur du substrat. Ainsi, par rapport aux architectures existantes de cellules photovoltaïques, cette disposition des jonctions p-n dans la cellule photovoltaïque permet d'optimiser la collecte et le transport des porteurs de charges minoritaires à l'intérieur de la cellule photovoltaïque, autorisant ainsi l'utilisation de semi-conducteurs de qualité inférieure à la qualité microélectronique pour sa réalisation, comme par exemple des poudres de semi-conducteur mélangées à des polymères. Cette cellule peut donc être réalisée à bas coût grâce par exemple à des techniques issues de la micro-plasturgie.

De plus, par rapport aux cellules photovoltaïques de type EWT, la cellule photovoltaïque selon l'invention offre de plus grandes possibilités d'ajustement des dimensions, des positionnements et d'espacement des portions de semi-conducteur formant l'émetteur de la cellule. Par rapport à la technologie EWT, cette architecture de cellule photovoltaïque permet en outre l'utilisation de faibles niveaux de dopages des semi-conducteurs pour une conductance équivalente.

Chaque trou borgne peut comporter un axe de symétrie centrale sensiblement perpendiculaire aux deux faces principales du substrat. L'émetteur de la cellule est ainsi formé par des portions longitudinales de semi-conducteur disposées dans le substrat de la cellule photovoltaïque.

Chaque trou borgne peut comporter, dans un plan passant par la face principale du substrat comprenant les ouvertures des trous borgnes, une section de surface supérieure à la surface de la paroi de fond dudit trou borgne. Ainsi, en choisissant de tels trous borgnes, et donc de telles portions de semi-conducteur pour former l'émetteur de la cellule photovoltaïque, la surface de la section de ces trous borgnes varie avec la hauteur du trou borgne dans le substrat pour tenir compte de l'absorption spectrale des photons incidents par le semi-conducteur disposé dans le substrat, ce qui permet d'améliorer le transport des porteurs de charges minoritaires.

Dans ce cas, pour chaque trou borgne, le rapport entre la surface de la section dudit trou borgne au niveau du plan passant par la face principale du substrat comprenant les ouvertures des trous borgnes et la surface de la paroi de fond dudit trou borgne peut être compris entre 1 et 3.

Chaque trou borgne peut avoir une forme sensiblement conique ou ogivale tronquée.

Chaque trou borgne peut comporter, dans un plan parallèle à l'une des faces principales du substrat, une section de forme polygonale, ou par exemple une forme d'étoile. Ainsi, en choisissant des profils particuliers pour les portions de semi-conducteur formant l'émetteur de la cellule, on augmente la probabilité de collecte des porteurs de charges minoritaires en augmentant la surface de l'émetteur par rapport à un volume donné dans le substrat, au moyen de formes transverses originales de ces portions semi-conductrices formant l'émetteur de la cellule photovoltaïque.

Au moins l'une des faces principales du substrat peut être structurée, améliorant ainsi le piégeage de la lumière par la cellule photovoltaïque.

La concentration en atomes dopants, ou atomes porteurs, par centimètre cube dans le semi-conducteur du second type de conductivité de l'émetteur peut être comprise entre 10¹⁶ et 10²¹, et de préférence comprise entre 10¹⁸ et 10²⁰. La concentration en atomes dopants par centimètre cube dans le semi-conducteur du premier type de conductivité du substrat peut être comprise entre 10¹⁵ et 10¹⁸, et de préférence comprise entre 10¹⁶ et 10¹⁷.

De manière avantageuse, l'épaisseur du substrat peut être inférieure à 300 µm et la profondeur de chaque trou borgne peut avantageusement être supérieure à la moitié de l'épaisseur du substrat.

La cellule photovoltaïque comporte en outre, sur la face principale du substrat comportant les ouvertures des trous borgnes, des premiers doigts de collecte à base d'au moins un semi-conducteur du second type de conductivité en contact avec l'émetteur de la cellule, et des seconds doigts de collecte à base d'au moins un semi-conducteur du premier type de conductivité en contact avec le substrat et interdigités avec les premiers doigts de collecte.

Dans ce cas, les concentrations en atomes dopants par centimètre cube dans les semi-conducteurs du premier type de conductivité des seconds doigts de collecte et du second type de conductivité des premiers doigts de collecte peuvent être comprises entre 10¹⁹ et 10²¹.

L'invention concerne en outre un procédé de réalisation d'une cellule photovoltaïque selon la revendication 11.

L'étape a) peut être mise en oeuvre par une injection d'un matériau à base de semi-conducteur d'un premier type de conductivité dans un moule.

Au cours de ce procédé, il est possible de garder le substrat dans le moule initial en retirant le fond de ce dernier pour faciliter tous les problèmes d'alignement.

L'étape c) de remplissage réalise en outre, sur la face principale du substrat comportant les ouvertures des trous borgnes, et à travers un premier masque disposé contre ladite face du substrat comportant les ouvertures des trous borgnes, des premiers doigts de collecte à base d'au moins un semi-conducteur du second type de conductivité en contact avec l'émetteur de la cellule, et comportant en outre après l'étape c), le retrait du premier masque et la réalisation de seconds doigts de collecte à base d'au moins un semi-conducteur du premier type de conductivité en contact avec le substrat et interdigités avec les premiers doigts de collecte par injection à travers un second masque disposé contre ladite face du substrat comportant les ouvertures des trous borgnes.

Le substrat et/ou l'émetteur et/ou les doigts de collecte peuvent être réalisés à partir d'un mélange de matériaux à base de poudres de semi-conducteurs et de polymères, et le procédé peut comporter en outre, après l'étape c) de remplissage, une étape de déliantage du mélange mise en oeuvre à une température comprise entre environ 300°C et 600°C, pendant une durée comprise entre environ 12 heures et 36 heures, et une étape de frittage des poudres obtenues après déliantage réalisée à une température comprise entre environ 1000°C et 1350°C, pendant une durée comprise entre environ 1 heure et 8 heures.

L'étape de déliantage et/ou l'étape de frittage peuvent être réalisées sous atmosphère réductrice, par exemple sous atmosphère d'hydrogène.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente une vue partielle, en coupe et de profil, d'une cellule photovoltaïque, objet de la présente invention, selon un mode de réalisation particulier,
- la figure 2 représente une vue de dessous partielle d'une cellule photovoltaïque, objet de la présente invention, selon un mode de réalisation particulier,
- la figure 3 représente une vue en coupe partielle d'une cellule photovoltaïque, objet de la présente invention, selon un mode de réalisation particulier,
- la figure 4 représente des exemples de profils et de sections de trous borgnes réalisés dans des substrats de cellules photovoltaïques, objets de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

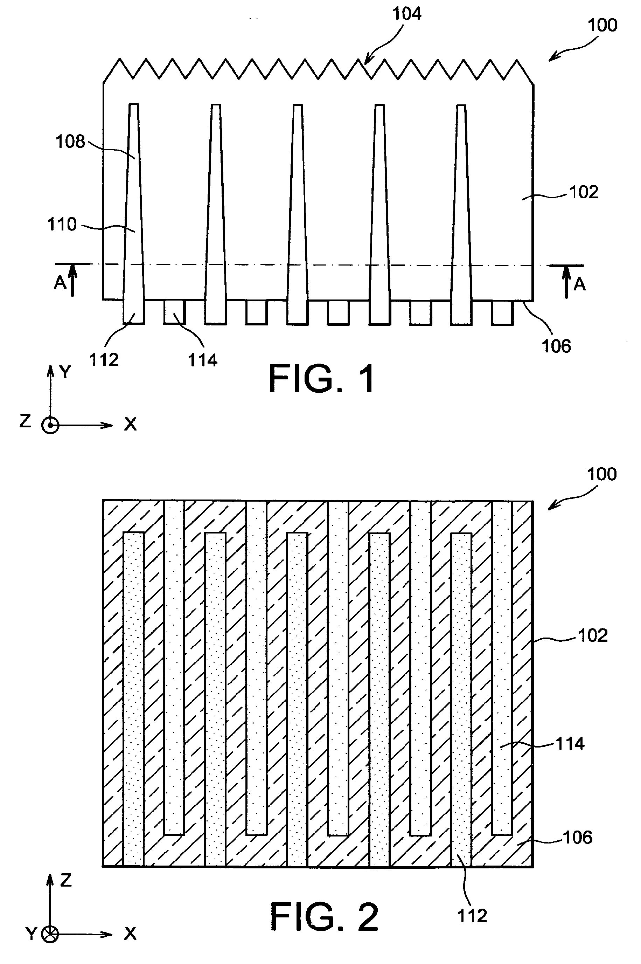

On se réfère tout d'abord à la figure 1 qui représente une vue partielle, en coupe et de profil, d'une cellule photovoltaïque 100 selon un mode de réalisation particulier.

La cellule photovoltaïque 100, ici de type p, comporte un substrat 102 à base de silicium de type p. Ce substrat 102 comporte une face avant 104 destinée à recevoir les rayons lumineux, ainsi qu'une face arrière 106. Sur l'exemple de la figure 1, la face avant 104 est texturée afin de mieux piéger la lumière arrivant dans la cellule photovoltaïque 100. Dans une variante de réalisation, la face arrière 106 pourrait également être structurée, de manière similaire ou non à la face avant 104. L'épaisseur du substrat 102 est par exemple comprise entre environ 50 µm et 300 µm, et avantageusement comprise entre environ 100 µm et 200 µm.

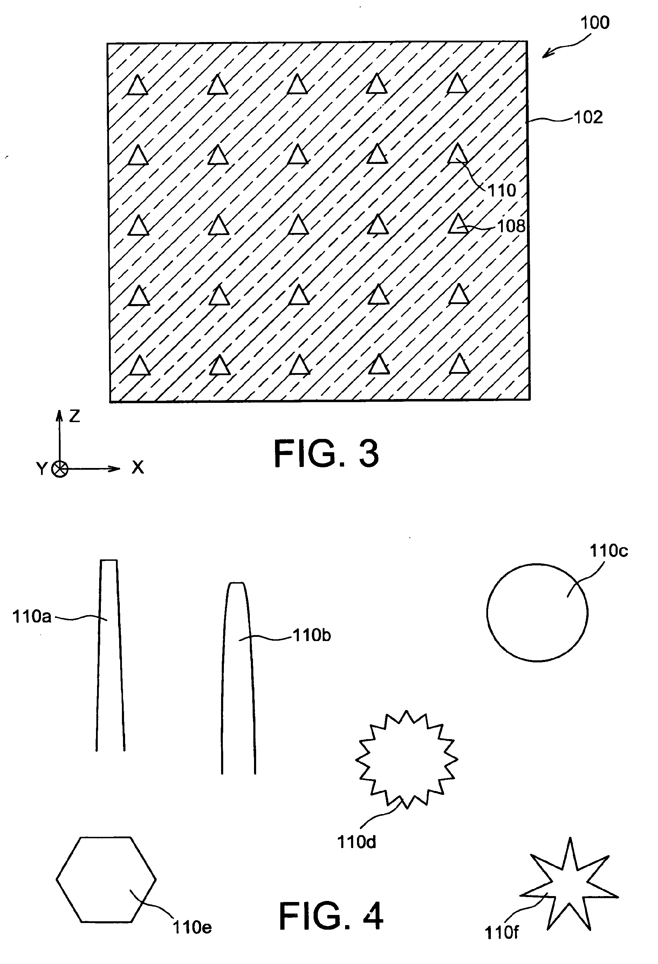

Des trous borgnes 108 sont formés dans le substrat 102, chaque trou borgne 108 présentant une ouverture au niveau de la face arrière 106 du substrat 102. Comme représenté sur la figure 1, les trous borgnes 108 ont des profils tels que la surface de la section des trous borgnes 108 au niveau de la face arrière 106 est supérieure à la surface de la paroi de fond des trous borgnes 108. La figure 3, qui est une vue en coupe de la cellule photovoltaïque 100 selon l'axe AA représenté sur la figure 1, permet de voir que les trous borgnes 108 ont ici une section, dans un plan parallèle à la face arrière 106, de forme triangulaire.

Les trous borgnes 108 sont remplis par un semi-conducteur 110, ici du silicium de type n+. Ainsi, les portions de silicium 110 forment l'émetteur de la cellule photovoltaïque 100 et le substrat 102 forme la base de la cellule photovoltaïque 100. Ainsi, on obtient des jonctions p-n distribuées dans tout le volume de la cellule photovoltaïque 100.

La collecte du courant généré dans la cellule photovoltaïque 100 est réalisée par des premiers doigts de collecte 112, à base de silicium de type n+ et en contact avec les portions de silicium 110, et qui sont interdigités avec des seconds doigts de collecte 114, à base de silicium de type p+ et en contact avec la face arrière 106 du substrat 102 (voir figures 1 et 2).

Les sections des trous borgnes 108, dans un plan parallèle à l'une des faces principales 104 et 106 du substrat 102, peuvent être de forme autre que triangulaire, par exemple circulaire (voir par exemple la section 110c représentée sur la figure 4). Toutefois, les sections des trous borgnes 108 sont choisies de préférence d'une forme autre que circulaire, par exemple triangulaire comme sur la figure 3, carrée, en étoile (voir par exemple les sections 110d et 110f représentées sur la figure 4), ou polygonale régulière ou non (voir par exemple la section octogonale 110e représentée sur la figure 4). Ces autres formes permettent d'augmenter la surface de contact entre le semi-conducteur 110 se trouvant dans les trous borgnes 108 (l'émetteur) et le substrat 102, ce qui permet d'augmenter la probabilité de collecte des porteurs de charges minoritaires dans la cellule photovoltaïque 100. A volume donné, une section de forme triangulaire permet d'augmenter d'environ 30 % la surface de l'émetteur par rapport à une section de forme circulaire. Toujours par rapport à une section de forme circulaire, une augmentation de surface proche d'un facteur 2 est obtenue avec une section de forme d'hexagramme régulier, constitué de la superposition de deux triangles équilatéraux. Enfin, en cas de besoin, des formes plus complexes peuvent être envisagées (polygones réguliers ou non à n côtés, ou superposition de triangles et/ou d'étoiles à n branches).

Selon la qualité du semi-conducteur utilisé et notamment de sa longueur de diffusion, la distance entre deux portions de semi-conducteur 110 voisines, correspondant à l'écart entre deux trous borgnes 108 voisins, peut être comprise entre environ 40 µm et 300 µm, et de préférence entre environ 60 µm et 100 µm.

Sur l'exemple de la figure 1, les trous borgnes 108 ont un profil tel que les dimensions des sections des trous borgnes 108 diminuent régulièrement en fonction de la distance de la section par rapport à la face arrière 106, par exemple un profil en forme de cône 110a (figure 4). Dans une variante, les trous borgnes 108 peuvent avoir des profils de forme différente, comme par exemple une ogivale tronquée (référence 110b sur la figure 4) dans laquelle la réduction des dimensions des sections n'est pas régulière tout le long du profil, mais a lieu principalement au niveau du fond des trous borgnes 108. Il est également possible que les trous borgnes 108 aient des profils de forme différente (par exemple cylindrique, c'est-à-dire que les dimensions des sections sont identiques tout le long du profil). Avantageusement, chaque trou borgne 108 comporte, dans un plan passant par la face arrière 106, une section de surface supérieure à la surface de la paroi de fond dudit trou borgne 108, comme c'est le cas sur l'exemple de la figure 1. Ainsi, la surface des sections des trous borgnes 108 varie avec la hauteur dans la cellule photovoltaïque 100 pour tenir compte de l'absorption spectrale des photons incidents par le matériau semi-conducteur du substrat 102. On peut par exemple avoir un rapport entre la surface de la section du trou 108 au niveau de la face arrière 106 et la surface de la paroi de fond du trou 108 compris entre environ 1 et 3, et de préférence compris entre environ 1,2 et 2. La valeur de ce rapport est notamment choisie en fonction de la source lumineuse via la courbe d'absorption des photons dans le matériau utilisé.

Pour limiter la perte de volume actif lié à la forte activité recombinante des zones n+ formées par les portions de silicium 110, on peut limiter au maximum le volume des trous borgnes 108 en tenant compte des contraintes technologiques liées à la réalisation des trous borgnes 108 sur le facteur de forme des trous. Le rapport entre la hauteur, c'est-à-dire la dimension selon l'axe y représente sur la figure 1, et la dimension d'un des côtés (ou du diamètre dans le cas d'un cercle) d'une section d'un des trous borgnes 108 peut par exemple être inférieur ou égale à 10. De plus, la hauteur des portions de semi-conducteur, correspondant à la profondeur des trous borgnes 108, est au moins égale à la moitié de l'épaisseur du substrat 102.

La cellule photovoltaïque 100 décrite précédemment est de type p, c'est-à-dire comporte des jonctions p-n formées par un substrat 102 à base de silicium de type p et du silicium 110 de type n+ disposé dans les trous borgnes 108. Dans une variante, la cellule photovoltaïque 100 pourrait être de type n, c'est-à-dire comportant des jonctions p-n formées par un substrat 102 à base de silicium de type n et du silicium 110 de type p+ disposé dans les trous borgnes 108. De plus, le semi-conducteur utilisé pour la réalisation de la cellule photovoltaïque 100 peut être un semi-conducteur autre que le silicium, par exemple du germanium. Dans l'exemple décrit précédemment, les doigts de collecte 112, 114 sont donc respectivement de type n+ et p+.

De façon générale, le substrat (de type p ou n) présente une concentration en atomes dopants par centimètre cube comprise entre 10¹⁵ et 10¹⁸, et avantageusement entre 10¹⁶ et 10¹⁷. L'émetteur présente une concentration en atomes dopants par centimètre cube comprise entre 10¹⁶ et 10²¹, et avantageusement comprise entre 10¹⁸ et 10²⁰. Les doigts de collecte présentent des concentrations en atomes dopants supérieures à celles des semi-conducteurs sur lesquels ils prennent contact. Ainsi, les premiers doigts de collecte présentent une concentration en atomes dopants par centimètre cube comprise entre 10¹⁹ et 10²¹, et avantageusement comprise entre 10²⁰ et 10²¹. Si le semi-conducteur formant l'émetteur a une concentration suffisamment élevée, il peut convenir pour constituer aussi les seconds doigts de collecte. Ces seconds doigts de collecte (base) peuvent donc présenter une concentration en atomes dopants par centimètre cube comprise entre environ 10¹⁹ et 10²¹, et avantageusement comprise entre environ 5.10¹⁹ et 5.10²⁰.

On décrit maintenant un procédé de réalisation de la cellule photovoltaïque 100. Ce procédé met en oeuvre des technologies à bas coût dérivées de la micro-plasturgie, à partir de mélanges mères contenant des poudres de silicium dans une matrice porteuse polymères.

Pour la réalisation de la cellule photovoltaïque 100 de type p, on prépare tout d'abord 3 mélanges mères, ou charges, basés sur des poudres de silicium de type p, p+ et n+ et de polymères qui en particulier protègent les poudres de silicium de leur oxydation naturelle. Les polymères porteurs de ces mélanges sont de type polyoléfine, basés sur des monomères de type alcène. Des copolymères de plusieurs poly-alcènes peuvent également être utilisés. Dans l'exemple décrit ici, les poudres de silicium sont mélangées à du polyéthylène, et la fraction volumique de poudres de silicium est égale à environ 50%. Dans cet exemple de réalisation, la charge de type p présente une concentration en atomes de bore par centimètre cube égale à environ 5.10¹⁶. La charge de type p+ présente une concentration en atomes de bore par centimètre cube égale à environ 2.10²⁰. Enfin, la charge de type n+ présente une concentration en atomes de phosphore par centimètre cube égale à environ 2.10²⁰.

La première étape du procédé consiste à injecter la charge de type p dans un moule pour former le substrat 102. Lorsque l'on souhaite réaliser une face avant texturée, le moule peut reproduire la texture souhaitée pour cette face avant. Avantageusement, on peut aussi structurer la face arrière 106 de la cellule 100 pour améliorer encore l'optique de la cellule 100. La hauteur du moule peut être légèrement supérieure à l'épaisseur souhaitée du substrat 102. Dans l'exemple décrit ici, le moule a des dimensions latérales (correspondant aux dimensions selon les axes X et Z représentés sur la figure 2) égales à environ 10 cm, et une hauteur égale à environ 250 µm.

La partie basse du moule, c'est à dire le fond du moule contre lequel se trouve la face arrière 106 du substrat 102, est retirée, et le substrat 102 est alors imprimé par une matrice pour former de façon collective les trous borgnes 108 dans le substrat 102. Dans l'exemple décrit ici, pour un matériau de longueur de diffusion égale à environ 100 µm et un substrat de 250 µm d'épaisseur, ce substrat 102 est imprimé par une matrice à base de nickel pouvant comporter des doigts (destinés à s'enfoncer dans le substrat 102 pour former les trous borgnes 108) en forme de cône tronqué et de section en forme triangulaire, le coté du triangle équilatéral ayant une dimension évoluant de 30 µm à 40 µm entre le haut et le bas du trou. Les trous borgnes 108 sont réalisés sur une profondeur égale à environ 200 µm, et espacés les uns des autres d'une distance égale à environ 200 µm. De façon générale, l'espacement sera choisi en fonction de la qualité du semi-conducteur constituant le substrat : il sera avantageusement inférieur à 2 fois la valeur de la longueur de diffusion des porteurs minoritaires

Un premier masque, ne laissant à découvert que les emplacement des doigts de collecte 112 destinés à être en contact avec les portions de semi-conducteur 110, est ensuite appliqué contre la face arrière 106, et la charge n+ est injectée dans les trous borgnes 108 pour former les portions de semi-conducteur 110 formant l'émetteur de la cellule photovoltaïque 100. Ce masque a une certaine hauteur, par exemple égale à environ 20 µm, pour former également les premiers doigts de collecte 112.

Le premier masque est retiré, et un second masque permettant de réaliser les seconds doigts de collecte 114 à partir de la charge de silicium p+ est ensuite appliqué contre la face arrière 106.

Selon la nature du polymère porteur utilisé, la cellule 100 est soumise à une étape de déliantage dont la durée varie entre environ 12 heures et 36 heures, préférentiellement comprise entre environ 18 heures et 30 heures, à une température comprise entre environ 300°C et 600°C, préférentiellement comprise entre environ 400°C à 500°C. Dans l'exemple décrit ici, l'étape de déliantage est réalisée dans un four résistif pendant environ 24 heures, à une température égale à environ 450°C

La structure obtenue à l'issue de l'étape de déliantage est soumise à une étape de frittage, dont la durée varie entre environ 1 heure et 8 heures, préférentiellement entre environ 3 heures et 6 heures, à une température comprise entre environ 1000°C et 1350°C, préférentiellement comprise entre environ 1200°C et 1300°C. Dans l'exemple décrit ici, l'étape de frittage est réalisée pendant environ 4 heures à 1300°C.

Ces étapes de déliantage et/ou de frittage sont de préférence réalisées en atmosphère réductrice, préférentiellement sous hydrogène ou argon-hydrogéné pour permettre l'hydrogénation à coeur du silicium de la cellule photovoltaïque 100.

## Revendications

1. Cellule photovoltaïque (100) comportant un substrat (102) à base de semi-conducteur d'un premier type de conductivité comportant deux faces principales (104, 106) parallèles l'une par rapport à l'autre, le substrat (102) comprenant une pluralité de trous borgnes (108) dont des ouvertures sont disposées au niveau d'une seule (106) des deux faces principales, les trous borgnes (108) étant remplis par un semi-conducteur (110) d'un second type de conductivité opposé au premier type de conductivité formant l'émetteur de la cellule photovoltaïque (100), le substrat (102) formant la base de la cellule photovoltaïque (100), **caractérisée en ce que** la cellule photovoltaïque (100) comporte en outre, sur la face principale (106) du substrat (102) comportant les ouvertures des trous borgnes (108), des premiers doigts de collecte (112) à base d'au moins un semi-conducteur du second type de conductivité en contact avec l'émetteur (110) de la cellule photovoltaïque (100), et des seconds doigts de collecte (114) à base d'au moins un semi-conducteur du premier type de conductivité en contact avec le substrat (102) et interdigités avec les premiers doigts de collecte (112).

2. Cellule photovoltaïque (100) selon la revendication 1, dans laquelle chaque trou borgne (108) comporte un axe de symétrie centrale perpendiculaire aux deux faces principales (104, 106) du substrat (102).

3. Cellule photovoltaïque (100) selon l'une des revendications précédentes, dans laquelle chaque trou borgne (108) comporte, dans un plan passant par la face principale (106) du substrat (102) comprenant les ouvertures des trous borgnes (108), une section de surface supérieure à la surface de la paroi de fond dudit trou borgne (108).

4. Cellule photovoltaïque (100) selon la revendication 3, dans laquelle, pour chaque trou borgne (108), le rapport entre la surface de la section dudit trou borgne (108) au niveau du plan passant par la face principale (106) du substrat (102) comprenant les ouvertures et la surface de la paroi de fond dudit trou borgne (108) est compris entre 1 et 3.

5. Cellule photovoltaïque (100) selon l'une des revendications précédentes, dans laquelle chaque trou borgne (108) a une forme conique ou ogivale tronquée.

6. Cellule photovoltaïque (100) selon l'une des revendications précédentes, dans laquelle chaque trou borgne (108) comporte, dans un plan parallèle à l'une des faces principales (104, 106) du substrat (102), une section de forme polygonale.

7. Cellule photovoltaïque (100) selon l'une des revendications précédentes, dans laquelle au moins l'une des faces principales (104, 106) du substrat (102) est structurée.

8. Cellule photovoltaïque (100) selon l'une des revendications précédentes, dans laquelle la concentration en atomes dopants par centimètre cube dans le semi-conducteur (110) du second type de conductivité de l'émetteur est comprise entre 10¹⁶ et 10²¹, ou comprise entre 10¹⁸ et 10²⁰, et la concentration en atomes dopants par centimètre cube dans le semi-conducteur du premier type de conductivité du substrat (102) est compris entre 10¹⁵ et 10¹⁸, ou comprise entre 10¹⁶ et 10¹⁷.

9. Cellule photovoltaïque (100) selon l'une des revendications précédentes, dans laquelle l'épaisseur du substrat (102) est inférieure à 300 µm et la profondeur de chaque trou borgne (108) est supérieure à la moitié de l'épaisseur du substrat (102).

10. Cellule photovoltaïque (100) selon l'une des revendications précédentes, dans laquelle les concentrations en atomes dopants par centimètre cube dans les semi-conducteurs du premier type de conductivité des seconds doigts de collecte (114) et du second type de conductivité des premiers doigts de collecte (112) est comprise entre 10¹⁹ et 10²¹.

11. Procédé de réalisation d'une cellule photovoltaïque (100), comportant au moins les étapes de :
a) réalisation d'un substrat (102) à base de semi-conducteur d'un premier type de conductivité comportant deux faces principales (104, 106) parallèles l'une par rapport à l'autre,
b) réalisation d'une pluralité de trous borgnes (108) dans le substrat (102), des ouvertures des trous borgnes (108) étant disposées au niveau d'une seule (106) des deux faces principales,
c) remplissage des trous borgnes (108) par un matériau à base d'un semi-conducteur d'un second type de conductivité, opposé au premier type de conductivité, formant l'émetteur (110) de la cellule photovoltaïque (100),
dans lequel l'étape c) de remplissage réalise en outre, sur la face principale (106) du substrat (102) comportant les ouvertures des trous borgnes (108) et à travers un premier masque disposé contre ladite face (106) du substrat (102) comportant les ouvertures des trous borgnes (108), des premiers doigts de collecte (112) à base d'au moins un semi-conducteur du second type de conductivité en contact avec l'émetteur (110) de la cellule (100), et comportant en outre après l'étape c), le retrait du premier masque et la réalisation de seconds doigts de collecte (114) à base d'au moins un semi-conducteur du premier type de conductivité en contact avec le substrat (102) et interdigités avec les premiers doigts de collecte (112) par injection à travers un second masque disposé contre ladite face (106) du substrat (102) comportant les ouvertures des trous borgnes (108).

12. Procédé de réalisation selon la revendication 11, dans lequel l'étape a) est mise en oeuvre par une injection d'un matériau à base de semi-conducteur d'un premier type de conductivité dans un moule.

13. Procédé de réalisation selon l'une des revendications 11 ou 12, dans lequel le substrat (102) et/ou l'émetteur (110) et/ou les doigts de collecte (112, 114) sont réalisés à partir d'un mélange de matériaux à base de poudres de semi-conducteurs et de polymères, et le procédé comporte en outre, après l'étape c) de remplissage, une étape de déliantage du mélange mise en oeuvre à une température comprise entre environ 300°C et 600°C, pendant une durée comprise entre environ 12 heures et 36 heures, et une étape de frittage des poudres obtenues après déliantage réalisée à une température comprise entre 1000°C et 1350°C, pendant une durée comprise entre 1 heure et 8 heures.

14. Procédé de réalisation selon la revendication 13, dans lequel l'étape de déliantage et/ou l'étape de frittage sont réalisées sous atmosphère réductrice.

## Claims

1. A photovoltaic cell (100) including a substrate (102) composed of a semiconductor of a first type of conductivity including two main faces (104, 106) which are parallel with one another, where the substrate (102) includes a plurality of blind holes (108), openings of which are located in a single (106) one of the two main faces, and where the blind holes (108) are filled by a semiconductor (110) of a second type of conductivity opposed to the first type of conductivity forming the emitter of the photovoltaic cell (100), where the substrate (102) forms the base of the photovoltaic cell (100), **characterized in that** the photovoltaic cell (100) also includes, on the main face (106) of the substrate (102) including the openings of the blind holes (108), first collector pins (112) composed of at least one semiconductor of the second type of conductivity in contact with the emitter (110) of the photovoltaic cell (100), and second collector pins (114) composed of at least one semiconductor of the first type of conductivity in contact with the substrate (102) and interdigitated with the first collector pins (112).

2. Photovoltaic cell (100) according to claim 1, in which each blind hole (108) has a central axis of symmetry which is perpendicular to the two main faces (104, 106) of the substrate (102).

3. Photovoltaic cell (100) according to one of the previous claims, in which each blind hole (108) includes, in a plane passing through the main face (106) of the substrate (102) including the openings of the blind holes (108), a section of area greater than the area of the bottom wall of the said blind hole (108).

4. Photovoltaic cell (100) according to claim 3, in which, for each blind hole (108), the ratio between the area of the section of the said blind hole (108) at the level of the plane passing through the main face (106) of the substrate (102) where the openings of the blind holes are located and the area of the bottom wall of the said blind hole (108) is between 1 and 3.

5. Photovoltaic cell (100) according to one of the previous claims, in which each blind hole (108) has a truncated conical or ogival shape.

6. Photovoltaic cell (100) according to one of the previous claims, in which each blind hole (108) has, in a plane parallel to one of the main faces (104, 106) of the substrate (102), a section of polygonal shape.

7. Photovoltaic cell (100) according to one of the previous claims, in which at least one of the main faces (104, 106) of the substrate (102) is structured.

8. Photovoltaic cell (100) according to one of the previous claims, in which the doping atoms concentration per cubic centimetre in the semiconductor (110) of the second type of conductivity of the emitter is between 10¹⁶ and 10²¹, or between 10¹⁸ and 10²⁰, and the doping atoms concentration per cubic centimetre in the semiconductor of the first type of conductivity of the substrate (102) is between 10¹⁵ and 10¹⁸, or between 10¹⁶ and 10¹⁷.

9. Photovoltaic cell (100) according to one of the previous claims, in which the thickness of the substrate (102) is less than 300 µm and the depth of each blind hole (108) is greater than half the thickness of the substrate (102).

10. Photovoltaic cell (100) according to one of the previous claims, in which the doping atoms concentrations per cubic centimetre in the semiconductors of the first type of conductivity of the second collector pins (114) and of the second type of conductivity of the first collector pins (112) is between 10¹⁹ and 10²¹.

11. A method for producing a photovoltaic cell (100), including at least the following steps:
a) production of a substrate (102) composed of a semiconductor of a first type of conductivity having two main faces (104, 106) which are parallel one with the other,
b) production of a plurality of blind holes (108) in the substrate (102), such that the openings of the blind holes (108) are positioned in one only (106) of the two main faces,
c) filling of the blind holes (108) by a material composed of a semiconductor of a second type of conductivity, opposed to the first type of conductivity, forming the emitter (110) of the photovoltaic cell (100),
in which step c) of filling also products, on the main face (106) of the substrate (102) where the openings of the blind holes (108) are located, and through a first mask placed against the said face (106) of the substrate (102) having the openings of the blind holes (108), first collector pins (112) composed of at least one semiconductor of the second type of conductivity in contact with the emitter (110) of the cell (100), and also including after step c) the removal of the first mask and the production of second collector pins (114) composed of at least one semiconductor of the first type of conductivity in contact with the substrate (102) and interdigitated with the first collector pins (112) by injection through a second mask placed against the said face (106) of the substrate (102) where the openings of the blind holes (108) are located.

12. Method according to claim 11, in which step a) is implemented by an injection of a material composed of a semiconductor of a first type of conductivity into a mould.

13. Method according to one of the claims 11 or 12, in which the substrate (102) and/or the emitter (110) and/or the collector pins (112, 114) are produced from a blend of materials composed of semiconductor and polymers powders, and the method also includes, after the step c) of filling, a step of debinding of the blend undertaken at a temperature of between approximately 300°C and 600°C, over a period of between 12 hours and 36 hours, and a step of fritting of the powders obtained after debinding accomplished at a temperature of between approximately 1000°C and 1350°C, over a period of between approximately 1 hour and 8 hours.

14. Method according to claim 13, in which the debinding step and/or the fritting step are undertaken in a reducing atmosphere.

## Patentansprüche

1. Photovoltaikzelle (100) mit einem Substrat (102) auf Basis eines Halbleiters eines ersten Leitfähigkeitstyps, zwei zueinander parallele Hauptflächen (104, 106) umfassend, wobei das Substrat (102) eine Vielzahl Grundlöcher (108) aufweist, deren Öffnungen sich auf nur einer (106) der beiden Hauptflächen befinden, und die Grundlöcher (108) gefüllt sind mit einem den Emitter der Photovoltaikzelle (100) bildenden Halbleiter (110) eines dem ersten Leitfähigkeitstyp entgegengesetzten zweiten Leitfähigkeitstyps und das Substrat (102) dabei die Basis der Photovoltaikzelle (100) bildet,
**dadurch gekennzeichnet, dass** die Photovoltaikzelle (100) außerdem auf der die Öffnungen der Grundlöcher (108) umfassenden Hauptfläche (106) des Substrats (102) erste Kollektorfinger (112) auf der Basis wenigstens eines Halbleiters des zweiten Leitfähigkeitstyps, in Kontakt mit dem Emitter (110) der Photovoltaikzelle (100), und zweite Kollektorfinger (114) auf der Basis wenigstens eines Halbleiters des ersten Leitfähigkeitstyps, in Kontakt mit dem Substrat (102) und mit den ersten Kollektorfingern (112) ineinandergreifend, umfasst.

2. Photovoltaikzelle (100) nach Anspruch 1, bei der jedes Grundloch (108) eine zentrale Symmetrieachse senkrecht zu den beiden Hauptflächen (104, 106) des Substrats (102) umfasst.

3. Photovoltaikzelle (100) nach einem der vorhergehenden Ansprüche, bei der jedes Grundloch (108) in einer Ebene, die der die Öffnungen der Grundlöcher (108) enthaltenden Hauptfläche (106) des Substrats (102) entspricht, eine Querschnittfläche aufweist, die größer ist als die Fläche der Bodenwand des genannten Grundlochs (108).

4. Photovoltaikzelle (100) nach Anspruch 3, bei der für jedes Grundloch (108) das Verhältnis zwischen der Fläche des Querschnitts des genannten Grundlochs (108) in Höhe der der die Öffnungen enthaltenden Hauptfläche (106) des Substrats (102) entsprechenden Ebene und der Fläche der Bodenwand des genannten Grundlochs (108) zwischen 1 und 3 enthalten ist.

5. Photovoltaikzelle (100) nach einem der vorhergehenden Ansprüche, bei der jedes Grundloch (108) eine konische oder stumpf-ogivale Form hat.

6. Photovoltaikzelle (100) nach einem der vorhergehenden Ansprüche, bei der jedes Grundloch (108) in einer zu einer der Hauptflächen (104, 106) des Substrats (102) parallelen Ebene einen Querschnitt von polygonaler Form hat.

7. Photovoltaikzelle (100) nach einem der vorhergehenden Ansprüche, bei der wenigstens eine der Hauptflächen (104, 106) des Substrats (102) strukturiert ist.

8. Photovoltaikzelle (100) nach einem der vorhergehenden Ansprüche, bei der die Konzentration an Dotieratomen pro Kubikzentimeter in dem Halbleiter (110) des zweiten Leitfähigkeitstyps des Emitters zwischen 10¹⁶ und 10²¹ oder zwischen 10¹⁸ und 10²⁰ enthalten ist, und die Konzentration an Dotieratomen pro Kubikzentimeter in dem Halbleiter des ersten Leitfähigkeitstyps des Substrats (102) zwischen 10¹⁵ und 10¹⁸ oder zwischen 10¹⁶ und 10¹⁷ enthalten ist.

9. Photovoltaikzelle (100) nach einem der vorhergehenden Ansprüche, bei der die Dicke des Substrats (102) kleiner ist als 300 µm, und die Tiefe jedes Grundlochs (108) größer ist als die Hälfte der Dicke des Substrats (102).

10. Photovoltaikzelle (100) nach einem der vorhergehenden Ansprüche, bei der die Konzentrationen an Dotieratomen pro Kubikzentimeter in den Halbleitern des ersten Leitfähigkeitstyps der zweiten Kollektorfinger (114) und des zweiten Leitfähigkeitstyps der ersten Kollektorfinger (112) zwischen 10¹⁹ und 10²¹ enthalten ist.

11. Verfahren zur Herstellung einer Photovoltaikzelle (100), wenigstens die folgenden Schritte umfassend:
a) Herstellen eines Substrats (102) auf der Basis eines ersten Leitfähigkeitstyps, das zwei zueinander parallele Hauptflächen (104, 106) aufweist,
b) Realisieren einer Vielzahl von Grundlöchern (108) in dem Substrat (102), wobei die Öffnungen der Grundlöcher (108) nur auf einer (106) der beiden Hauptflächen angeordnet sind,
c) Füllen der Grundlöcher (108) mit einem Material auf der Basis eines Halbleiters eines dem ersten Leitfähigkeitstyp entgegengesetzten zweiten Leitfähigkeitstyps, der den Emitter (110) der Photovoltaikzelle (100) bildet,
bei dem in dem Füllschritt c) außerdem auf der die Öffnungen der Grundlöcher (108) enthaltenden Hauptfläche (106) des Substrats (102) erste Kollektorfinger (112) auf der Basis wenigstens eines Halbleiters des zweiten Leitfähigkeitstyps in Kontakt mit dem Emitter (110) der Zelle (100) realisiert werden, und außerdem nach dem Schritt c) die erste Maske beseitigt wird und die zweiten Kollektorfinger (114) auf der Basis wenigstens eines Halbleiters des ersten L.eitfähigkeitstyps, in Kontakt mit dem Substrat (102) und mit den ersten Kollektorfingern (112) ineinandergreifend, durch Einspritzung durch eine zweite Maske hindurch realisiert werden, angeordnet auf der genannten, die Öffnungen der Grundlöcher (108) enthaltenden Fläche (106) des Substrats (102).

12. Herstellungsverfahren nach Anspruch 11, bei dem der Schritt a) durch eine Einspritzung eines Materials auf der Basis eines Halbleiters eines ersten Leitfähigkeitstyps realisiert wird.

13. Herstellungsverfahren nach einem der Ansprüche 11 oder 12, bei dem das Substrat (102) und/oder der Emitter (110) und/oder die Kollektorfinger (112, 114) aus einem Materialgemisch auf der Basis von Pulvern von Halbleitern und von Polymeren realisiert wird, und das Verfahren außerdem nach dem Füllschritt c) einen Schritt zur Eliminierung des Gemisch-Bindemittels bei einer zwischen ungefähr 300 °C und 600 °C enthaltenen Temperatur während einer Dauer zwischen 12 Stunden und 36 Stunden und einen Schritt zur Sinterung der nach den Bindemittel-Eliminierung erhaltenen Pulver bei einer zwischen 1000 °C und 1350 °C enthaltenen Temperatur während einer Dauer von 1 bis 8 Stunden umfasst.

14. Herstellungsverfahren nach Anspruch 13, bei dem der Bindemittel-Eliminierungsschritt und/oder der Sinterschritt unter reduzierender Atmosphäre realisiert wird.
